# EUROPEAN PATENT SPECIFICATION

(11) **EP 2 918 637 B1**
(45) Date of publication and mention of the grant of the patent: **12.12.2018**
(21) Application number: 13852401.2
(22) Date of filing: 02.10.2013
(51) Int. Cl.: C08L 51/04, C08L 63/00, B32B 15/092, H05K 1/03, C08G 59/18

(54) **RESIN COMPOSITION, AND LAMINATE FOR PRINTED CIRCUIT BOARD COMPRISING SAME**
HARZZUSAMMENSETZUNG UND LAMINAT FÜR LEITERPLATTE DAMIT
COMPOSITION DE RÉSINE ET LAMINÉ POUR CARTE DE CIRCUIT IMPRIMÉ COMPRENANT LA COMPOSITION

(30) Priority: 09.11.2012 KR 20120126700
(43) Date of publication of application: 16.09.2015
(73) Proprietor: Doosan Corporation, Seoul 100-730 (KR)
(72) Inventor: LEE, hang seok, Uijeongbu-si Gyeonggi-do 480-090 (KR); HAN, duk sang, Daejeon 301-782 (KR); JUNG, yoon ho, Yongin-si Gyeonggi-do 448-950 (KR); YANG, dong bo, Yongin-si Gyeonggi-do 446-916 (KR)
(74) Representative: Isarpatent
(86) International application number: PCT/KR2013/008824
(87) International publication number: WO 2014/073789

(56) References cited:
- WO-A2-2012/044029
- JP-A- 2008 213 426
- KR-A- 20030 034 106
- KR-A- 20100 045 209
- KR-B1- 100 781 582
- US-A1- 2012 064 231
- US-A1- 2012 111 618
- HSIEH T H ET AL: "The toughness of epoxy polymers and fibre composites modified with rubber microparticles and silica nanoparticles", JOURNAL OF MATERIALS SCIENCE, KLUWER ACADEMIC PUBLISHERS, BO, vol. 45, no. 5, 10 December 2009 (2009-12-10), pages 1193-1210, XP019770474, ISSN: 1573-4803

## Description

### [Technical Field]

The present disclosure relates to a laminate for use in a printed circuit board, and a resin composition for forming an insulation layer and/or an adhesive layer, which are/is included in the laminate.

### [Background Art]

A laminate for a printed circuit board includes a printed circuit layer in which an electronic circuit is formed and an electronic device such as a semiconductor is mounted, an insulation layer which conducts heat emitted from the electronic device, and a heat dissipation layer which is in contact with the insulation layer and emits heat to the outside.

The laminate for a printed circuit board is manufactured by laminating a flexible insulation film (which serves as an insulation layer) on a metal base layer (which serves as a heat dissipation layer) for improving electrical properties such as voltage resistance and thermal conductivity, and formability such as bendability (bending processability) and punchability, and a thermoplastic polyimide or an epoxy resin is used as an adhesive in order to increase adhesive force between the metal base layer and the insulation film.

However, for the thermoplastic polyimide, curing is conducted under high temperature conditions, and such curing conditions have problems in that photo solder resist (PSR) cracks are caused during the oxidation of the metal base layer and the manufacture of the printed circuit board, and adhesiveness and heat resistance deteriorate due to the compatibility of the epoxy resin with the insulation film.

Meanwhile, a technology of using a product obtained by mixing a rubber, such as acrylonitrile-butadiene rubber (NBR) or carboxyl terminated butadiene acrylonitrile (CTBN), with an epoxy resin as an adhesive has been introduced in order to improve adhesiveness and formability, but there is a limitation on obtaining desired heat resistance, insulation properties, formability, and the like required for a laminate for a printed circuit board. US 2012/064231 A1 relates to a method for manufacturing a printed circuit board including a flame retardant insulation layer. US 2012/111618 A1 relates to a flame-retardant resin composition for a multilayer wiring board and a multilayer wiring board having the same. A scientific publication by Hsieh, T. H. et al investigates the effect of adding silica nanoparticles to an anhydride-cured epoxy polymer in bulk and when used as the matrix of carbon- and glass-fibre reinforced composites (Hsieh, T. H., "The toughness of epoxy polymers and fibre composites modified with rubber microparticles and silica nanoparticles," Journal of Materials Science, vol. 45, no. 5, 2010, pages 1193-1210). WO 2012/044029 A2 relates to a laminate for a metal base printed circuit board, comprising a printed circuit layer, an insulation layer, and a metal heat-dissipating layer. JP 2008 213426 A relates to a metal foil with an insulating layer formed by providing an insulating layer on one main surface of a metal foil, the insulating layer containing an epoxy resin, a hardening agent, a hardening catalyst and an inorganic filler, and is in B-stage status (semi-hardened status) containing 40 mass% or more of a hydrogenated epoxy resin in the epoxy resin.

### [Disclosure]

### [Technical Problem]

In order to solve the aforementioned problems, an object of the present disclosure is to provide a resin composition which exhibits high adhesiveness to a metal base layer, and a laminate for a printed circuit board, which includes the resin composition and has excellent heat resistance, insulation properties, formability, and the like.

### [Technical Solution]

The technical solution to the problem is defined by the appended claims. The present disclosure provides a resin composition including: a rubber-modified epoxy resin; an epoxy resin; an inorganic filler; and a curing as defined by the present claims.

Further, the rubber-modified epoxy resin may have an epoxy equivalent weight of 300 to 500 g/eq and a weight average molecular weight (Mw) of 30,000 to 60,000.

Meanwhile, the present disclosure provides a laminate for a printed circuit board, including: a metal base layer; and a resin layer cured (hardened) by applying the resin composition on the metal base layer.

Further, the present disclosure provides a printed circuit board including the laminate for a printed circuit board.

### [Description of Drawings]

FIG. 1 is a cross-sectional view illustrating a laminate for a printed circuit board according to the present disclosure.
FIGS. 2 and 3 are cross-sectional views illustrating a printed circuit board according to the present disclosure.

### [Best Mode]

Hereinafter, the present disclosure will be described.

### 1. Resin Composition

A resin composition of the present disclosure includes a rubber-modified epoxy resin, an epoxy resin, an inorganic filler, and a curing agent.

The rubber-modified epoxy resin included in the resin composition of the present disclosure serves to increase adhesiveness, heat resistance, and insulation properties of the resin composition. In general, rubber is a polymer material having a linear structure, and has a small amount of unreacted groups. The unreacted groups of rubber degrades the crosslinking density of rubber to be cured because it is difficult for the unreacted groups to participate in curing reactions, and thus, are ultimately responsible for deterioration in heat resistance. Accordingly, the present disclosure uses a rubber-modified epoxy resin with curing reactivity improved while minimizing production of the unreacted groups of rubber by polymerizing the rubber with an epoxy resin. Here, the rubber-modified epoxy resin is a resin obtained by polymerizing carboxyl terminated butadiene acrylonitrile (CTBN) rubber with a phenol novolac-type epoxy resin, Meanwhile, when rubber is polymerized with an epoxy resin, the reaction ratio (wt%) is not particularly limited, but in consideration of adhesiveness, heat resistance, curing reactivity, and the like, rubber is reacted with the epoxy resin at a ratio of preferably 2:8 to 6:4, and more preferably 3:7.

It is preferred that the rubber-modified epoxy resin has an epoxy equivalent weight of 300 to 500 g/eq and a weight average molecular weight (Mw) of 30,000 to 60,000. This is because when a rubber-modified epoxy resin having an equivalent weight and a weight average molecular weight within the range is used, the adhesiveness, heat resistance, and insulation properties of the resin composition may be further increased. The term 'epoxy equivalent weight' in the present disclosure may be defined as a molecular weight of an epoxy copolymer per epoxy group.

Meanwhile, the content of the rubber-modified epoxy resin included in the resin composition of the present disclosure is not particularly limited, but in consideration of physical properties (adhesiveness, heat resistance, insulation properties, and the like) and manufacturing efficiency (manufacturing processes and costs) of the resin composition, it is preferred that the rubber-modified epoxyresin is included in an amount of 8 to 16 wt% based on 100 wt% of the resin composition.

The epoxy resin included in the resin composition of the present disclosure improves the crosslinking formability of the resin composition, thereby serving to stabilize adhesiveness, heat resistance, insulation properties, and environmental reliability of the resin composition. The epoxy resin is not particularly limited as long as the resin is publicly known in the art, but it is preferred to use one or more selected from the group consisting of a bisphenol A-type epoxy resin, a hydrogenated bisphenol A-type epoxy resin, a bisphenol F-type epoxy resin, a bisphenol S-type epoxy resin, a novolac-type epoxy resin, a cresol novolac-type epoxy resin, a phenol novolac-type epoxy resin, a dicyclopentadiene-type epoxy resin, a triphenylmethane-type epoxy resin, a naphthalene-type epoxy resin, a biphenyl-type epoxy resin, a hydrogenated biphenyl-type epoxy resin, and a phosphorus (P)-containing epoxy resin.

Meanwhile, the content of the epoxy resin included in the resin composition of the present disclosure is not particularly limited, but in consideration of physical properties (adhesiveness, heat resistance, insulation properties, and the like) and manufacturing efficiency (manufacturing processes and costs) of the resin composition, it is preferred that the epoxy resin is included in an amount of 50 to 65 wt% based on 100 wt% of the resin composition.

The inorganic filler included in the resin composition of the present disclosure serves to adjust the viscosity of the resin composition (improve formability) and increase thermal conductivity of the cured resin composition.

The inorganic filler is not particularly limited as long as the filler is publicly known in the art, but it is preferred to use one or more selected from the group consisting of silicon oxide, aluminum oxide, zinc oxide, aluminum nitride, silicon nitride, boron nitride, silica, talc, calcium carbonate, and magnesium carbonate.

Further, it is preferred to use the inorganic filler having an average particle diameter of about 1 µm or less. Specifically, it is more preferred to use the inorganic filler in which particles having a particle diameter of 1 µm or less and particles having a particle diameter of more than 1 µm and 5 µm or less are included in an amount of 60 to 80 vol% and 20 to 40 vol%, based on 100 vol% of the inorganic filler. The content of the inorganic filler included in the resin composition of the present disclosure is not particularly limited, but in consideration of viscosity, thermal conductivity, workability, formability, and the like of the resin composition, it is preferred that the inorganic filler is included in an amount of 5 to 10 wt% based on 100 wt% of the resin composition.

The curing agent (hardener) included in the resin composition of the present disclosure serves to cause a curing reaction of the rubber-modified epoxy resin with the epoxy resin. The curing agent is not particularly limited as long as the curing agent is publicly known in the art, but it is preferred to use one or more selected from the group consisting of amine-based curing agents.

In addition, the content of the curing agent included in the resin composition of the present disclosure is not particularly limited, but in consideration of curability (crosslinking density), workability, formability, and the like of the resin composition, it is preferred that the curing agent is included in an amount of 20 to 30 wt% based on 100 wt% of the resin composition.

Meanwhile, the resin composition of the present disclosure may further include a curing accelerator in order to increase the curing reaction rate of the composition. The curing accelerator is not particularly limited as long as the accelerator is publicly known in the art, but it is preferred to use one or more selected from the group consisting of a tertiary amine-based curing accelerator, such as benzyldimethylamine, triethanolamine, triethylenediamine, dimethylaminoethanol, and tri(dimethylaminomethyl)phenol; an imidazole-based curing accelerator, such as 2-methylimidazole and 2-phenylimidazole; an organic phosphine-based curing accelerator, such as triphenylphosphine, diphenylphosphine, and phenylphosphine; and tetraphenylboron salts, such as tetraphenylphosphonium tetraphenylborate and triphenylphosphine tetraphenylborate.

Furthermore, the content of the curing accelerator included in the resin composition of the present disclosure is also not particularly limited, but in consideration of curing reactivity, workability, formability, and the like of the resin composition, it is preferred that the curing accelerator is included in an amount of 1 wt% or less, specifically, 0.001 to 1 wt% based on 100 wt% of the resin composition.

The aforementioned resin composition of the present disclosure may further include additives publicly known in the art (for example, a defoaming agent, a dispersing agent, a viscosity adjusting agent, an antioxidant, and the like) without departing from the physical properties thereof and the effects exhibited.

The resin composition of the present disclosure may be used anywhere adhesiveness and/or insulation properties are needed, but it is preferred to use the resin composition in manufacturing a flexible printed circuit board.

### 2. Laminate for Printed Circuit Board and Printed Circuit Board Including the Same

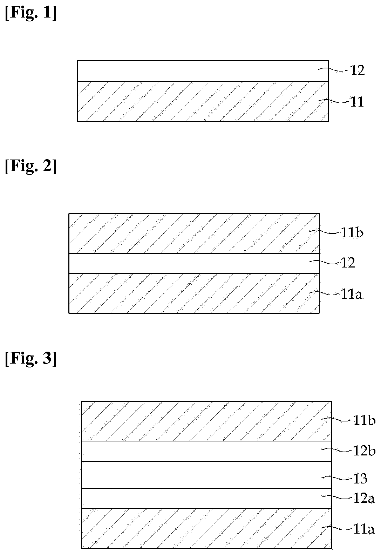

The present disclosure provides a laminate for a printed circuit board, which includes a metal base layer 11 and a resin layer 12 (see FIG. 1).

The metal base layer 11 included in the laminate for a printed circuit board according to the present disclosure serves as a heat dissipation layer which emits heat to the outside. A material, which may be used as the metal base layer 11, is not particularly limited, but it is possible to use aluminum (Al), copper (Cu), tin (Sn), gold (Au), silver (Ag), or a mixture thereof. Here, in consideration of heat dissipation properties and conductivity, and the like, it is preferred to use aluminum for the metal base layer 11.

The resin layer 12 included in the laminate for a printed circuit board according to the present disclosure is cured by applying the resin composition described above on the metal base layer 11, and serves as an insulation layer and an adhesive layer. Here, a method for applying the resin composition is not particularly limited as long as the method is publicly known in the art. Further, conditions of curing the resin composition are not particularly limited, but it is preferred that the resin composition is cured under a predetermined pressure condition at 160°C or more for 2 hours.

The resin layer 12 is formed of the resin composition and thus is excellent in heat resistance, insulation properties, and formability while exhibiting high adhesion strength with the metal base layer 11. Accordingly, the laminate for a printed circuit board according to the present disclosure, which includes the resin layer 12, may exhibit excellent heat resistance, insulation properties, and formability.

Meanwhile, the present disclosure also provides a printed circuit board including the laminate for a printed circuit board. Specifically, the printed circuit board of the present disclosure may have a structure in which a resin layer 12 serving as an insulation layer and an adhesive layer is inserted between a metal base layer 11a serving as a heat dissipation layer and a metal layer 11b for forming a circuit pattern (see FIG. 2), or may have a structure of a metal base layer 11a/a first resin layer 12a/a thermosetting polyimide film 13/a second resin layer 12b/a metal layer 11b for forming a circuit pattern, in order to increase insulation properties, durability, heat resistance, and the like (see FIG. 3). Here, the first resin layer 12a and the second resin layer 12b are obtained by curing the resin composition of the present disclosure, and the metal base layer 11a and the metal layer 11b are formed of a conductive metal, and may be formed of the same material or different materials.

A method for manufacturing the printed circuit board according to the present disclosure is not particularly limited, but the printed circuit board of the present disclosure may be manufactured by laminating a metal layer 11b having conductivity on a resin layer 12 or 12b of the laminate for a printed circuit board, and then forming a circuit pattern by a method such as etching, or forming a circuit pattern by an inkjet printing method of a metal material having conductivity.

Hereinafter, the present disclosure will be described in more detail with reference to Examples. However, the following Examples are preferred examples of the present disclosure, and the present disclosure is not limited to the following Examples.

### [Examples 1 to 6 and Comparative Examples 1 to 4]

A printed circuit board having a structure of a metal base layer (an aluminum foil)/a first resin layer/a thermosetting polyimide film/a second resin layer/a metal layer (a copper foil) was manufactured by a method publicly known in the art. In this case, the first resin layer and the second resin layer were each formed by each preparing resin compositions with the components and contents according to the following Table 1, and then curing the resin compositions.

Note Example 6 is not inventive.

**[Table 1]**

| | | Example 1 | Example 2 | Example 3 | Example 4 | Example 5 | Example 6 | Comparative Example 1 | Comparative Example 2 | Comparative Example 3 | Comparative Example 4 |
|---|---|---|---|---|---|---|---|---|---|---|---|
| Rubber-modifie d epoxy resin | CTBN+ Phenol novolac -type epoxy resin (Equiva lent weight: 300 to 500) | 4.4 | 8.3 | 12.0 | 15.4 | 18.5 | - | - | - | - | - |
| | CTBN+ Bisphen ol A-type epoxy resin (Equiva lent weight: 200 to 400) | - | - | - | - | - | 12.0 | - | - | - | - |
| Novolac-type epoxy resin (Equivalent weight: 100 to 250) | | 30.5 | 29.2 | 28.0 | 26.9 | 25.9 | 28.0 | - | 30.4 | 28.0 | 25.9 |
| Phosphorus-containing epoxy resin (Equivalent weight: 200 to 400) | | 30.5 | 29.2 | 28.0 | 26.9 | 25.9 | 28.0 | - | 30.4 | 28.0 | 25.9 |
| Thermoplastic polyimide resin | | - | - | - | - | - | - | 90.9 | - | - | - |
| CTBN | | - | - | - | - | - | - | - | 4.4 | 12.0 | 18.5 |
| Curing agent (Amine-based) | | 25.995 | 24.995 | 23.995 | 23.095 | 22.295 | 23.995 | - | 26.095 | 23.995 | 22.195 |
| Curing accelerator (Imidazole-based) | | 0.005 | 0.005 | 0.005 | 0.005 | 0.005 | 0.005 | - | 0.005 | 0.005 | 0.005 |
| Inorganic filler (Aluminum oxide) | | 8.6 | 8.3 | 8.0 | 7.7 | 7.4 | 8.0 | 9.1 | 8.7 | 8.0 | 7.5 |
| Total | | 100 | 100 | 100 | 100 | 100 | 100 | 100 | 100 | 100 | 100 |

### [Experimental Example]

The resin compositions of Examples 1 to 6 and Comparative Examples 1 to 4 and physical properties of each printed circuit board manufactured by using the same were evaluated by the following method, and the results are shown in the following Table 2.

### 1. Coatability

A resin composition was coated (applied) on a metal base layer (an aluminum foil), and then it was evaluated whether a fish eye, a pin hole, and a filler texture had been produced with respect to the coated surface.

### 2. Curing Reactivity

A first resin layer was formed by coating (applying) a resin composition on a metal base layer (an aluminum foil), and then curing the resin composition under a pressure of 30 kgf/cm² at 190°C for 2 hours. Thereafter, the curing state of the first resin layer formed and the degree of adhesion (lifted state) between the first resin layer and the metal base layer were evaluated by the unaided eye.

### 3. Punching Processability (Formability)

5,000 strokes were added to a printed circuit board prepared by applying 150 to 200 tons of punching weight, and then an evaluation was performed by measuring an insulation layer (first and second resin layers) and a fracture surface of PSR.

### 4. Heat Resistance

An evaluation was performed by floating a printed circuit board prepared at Solder 288°C according to the IPC TM-650 2.4.13 evaluation standard and measuring the time point until a separation phenomenon of the insulation layers (the first and second resin layers) occurs.

### 5. Withstand Voltage

Evaluation was performed by applying the voltage between the Φ1 inch circular circuit and the metal base layer at an insulation distance of 40 µm in accordance with the JIS C 2110 evaluation standard, to measure the fracture time point of the insulation layers (first and second resin layers).

### 6. Withstand Voltage after Treatment of High Temperature and High Moisture

An evaluation was performed by maintaining the prepared printed circuit board at 85°C and 85RH% for 100 hours, and then applying the same evaluation method as in the withstand voltage.

### 7. P/S (Adhesiveness)

An evaluation was performed by lifting a circuit pattern formed on the printed circuit board in accordance with the IPC-TM-650 2.4.8 evaluation standard in the direction of 90°, to measure the time point when a circuit pattern (copper foil) was peeled off.

**[Table 2]**

| Physical properties | Example 1 | Example 2 | Example 3 | Example 4 | Example 5 | Example 6 | Comparative Examp le 1 | Comparative Example 2 | Comparative Example 3 | Comparative Example 4 |
|---|---|---|---|---|---|---|---|---|---|---|
| Coatability | Good | Good | Good | Good | Good | Good | Good | Good | Good | Good |
| curing reactivity | ○ | ⊚ | ⊚ | ⊚ | ○ | ⊚ | × | ○ | Δ | Δ |
| Punching processability | ○ | ⊚ | ⊚ | ⊚ | ⊚ | ⊚ | - | ○ | ⊚ | ⊚ |
| Heat resistance (S/D @288) | >10 min | >10 min | >10 min | >10 min | >10 min | <5 min | - | <2 min | <2 min | <2 min |
| Withstand voltage (JIS C 2110) | 4.5 | 5.0 | 5.0 | 5.0 | 5.0 | 5.0 | - | 4.0 | 2.5 | 2.0 |
| Withstand voltage after treatment of high temperature and high moisture (JIS C 2110) | 4.0 | 4.0 | 4.0 | 3.5 | 3.0 | 2.5 | - | 2.0 | 1.0 | 1.0 |
| P/S (@10z-kgf/cm) | 1.6 | 1.6 | 1.5 | 1.4 | 1.3 | 1.6 | - | 1.4 | 1.0 | 0.8 |
| Excellent: ⊚ / Good: ○ / Fair: Δ / Bad: × | | | | | | | | | | |

Referring to Table 2, it can be confirmed that the printed circuit boards of Examples 1 to 6, in which the insulation layers and the adhesive layers were formed of the resin compositions of the present invention, which included a rubber-modified epoxy resin, are excellent in formability (punching processability), heat resistance, insulation properties (withstand voltage), and adhesiveness.

On the contrary, it can be confirmed that Comparative Example 1, in which the polyimide resin composition was used, was good in heat resistance, insulation properties, and adhesiveness, but the curing reactivity deteriorated when the curing temperature was set to be equal to that of the resin composition of the present disclosure (the curing temperature of a general polyimide resin composition needs a high temperature of 250°C or more). When the curing reactivity deteriorates as described above, the heat resistance and adhesiveness lead to a result which is not good.

In addition, it can be confirmed that in Comparative Examples 2 to 4 in which a resin composition obtained by simply mixing rubber with an epoxy resin was used, heat resistance, insulation properties, and adhesiveness deteriorated more than those of the resin compositions (Examples 1 to 6) of the present disclosure.

### [Industrial Applicability]

The laminate for a printed circuit board according to the present disclosure exhibits high adhesiveness with a metal base layer because a resin composition including a rubber-modified epoxy resin is used as an insulation layer and/or an adhesive layer, and is excellent in heat resistance, insulation properties, formability, and the like.

## Claims

1. A resin composition comprising:
a rubber-modified epoxy resin;
an epoxy resin;
an inorganic filler; and
a curing agent,
wherein the rubber-modified epoxy resin is a resin obtained by polymerizing carboxyl terminated butadiene acrylonitrile (CTBN) rubber with a phenol novolac-type epoxy resin.

2. The resin composition of claim 1, wherein the rubber-modified epoxy resin is included in an amount of 8 to 16 wt% based on 100 wt% of the resin composition.

3. The resin composition of claim 1, wherein the rubber-modified epoxy resin has an epoxy equivalent weight of 300 to 500 g/eq and a weight average molecular weight (Mw) of 30,000 to 60,000.

4. The resin composition of claim 1, wherein the epoxy resin is one or more selected from the group consisting of a bisphenol A-type epoxy resin, a hydrogenated bisphenol A-type epoxy resin, a bisphenol F-type epoxy resin, a bisphenol S-type epoxy resin, a novolac-type epoxy resin, a cresol novolac-type epoxy resin, a phenol novolac-type epoxy resin, a dicyclopentadiene-type epoxy resin, a triphenylmethane-type epoxy resin, a naphthalene-type epoxy resin, a biphenyl-type epoxy resin, a hydrogenated biphenyl-type epoxy resin, and a phosphorus (P)-containing epoxy resin.

5. The resin composition of claim 1, wherein the inorganic filler is one or more selected from the group consisting of silicon oxide, aluminum oxide, zinc oxide, aluminum nitride, silicon nitride, boron nitride, silica, talc, calcium carbonate, and magnesium carbonate.

6. The resin composition of claim 1, further comprising:
a curing accelerator.

7. The resin composition of claim 1, wherein based on 100 wt% of the resin composition, the resin composition comprises:
8 to 16 wt% of the rubber-modified epoxy resin;
50 to 65 wt% of the epoxy resin;
5 to 10 wt% of the inorganic filler; and
20 to 30 wt% of the curing agent.

8. A laminate for a printed circuit board, comprising:
a metal base layer; and
a resin layer cured by applying the resin composition of any one of claims 1 to 7 on the metal base layer.

9. A printed circuit board comprising the laminate for a printed circuit board of claim 8.

## Patentansprüche

1. Harzzusammensetzung, umfassend:
ein kautschukmodifiziertes Epoxidharz;
ein Epoxidharz;
einen anorganischen Füllstoff; und
einen Härter,
wobei das kautschukmodifizierte Epoxidharz ein Harz ist, das durch Polymerisieren von carboxylterminiertem Butadien-Acrylnitril (CTBN)-Kautschuk mit einem Epoxidharz vom Phenol-Novolac-Typ erhalten wird.

2. Harzzusammensetzung nach Anspruch 1, wobei das kautschukmodifizierte Epoxidharz in einer Menge von 8 bis 16 Gew.-% auf Grundlage von 100 Gew.-% der Harzzusammensetzung enthalten ist.

3. Harzzusammensetzung nach Anspruch 1, wobei das kautschukmodifizierte Epoxidharz ein Epoxid-Äquivalentgewicht von 300 bis 500 g/Äq. und ein gewichtsmittleres Molekulargewicht (Mw) von 30.000 bis 60.000 aufweist.

4. Harzzusammensetzung nach Anspruch 1, wobei das Epoxidharz eines oder mehrere ausgewählt aus der Gruppe bestehend aus einem Epoxidharz vom Bisphenol-A-Typ, einem Epoxidharz vom hydrierten Bisphenol-A-Typ, einem Epoxidharz vom Bisphenol-F-Typ, einem Epoxidharz vom Bisphenol-S-Typ, einem Epoxidharz vom Novolac-Typ, einem Epoxidharz vom Cresol-Novolac-Typ, einem Epoxidharz vom Phenol-Novolac-Typ, einem Epoxidharz vom Dicyclopentadien-Typ, einem Epoxidharz vom Triphenylmethan-Typ, einem Epoxidharz vom Naphthalin-Typ, einem Epoxidharz vom Biphenyl-Typ, einem Epoxidharz vom hydrierten Biphenyl-Typ und einem phosphor (P)-haltigen Epoxidharz ist.

5. Harzzusammensetzung nach Anspruch 1, wobei der anorganische Füllstoff einer oder mehrere ausgewählt aus der Gruppe bestehend aus Siliciumoxid, Aluminiumoxid, Zinkoxid, Aluminiumnitrid, Siliciumnitrid, Bornitrid, Siliciumdioxid, Talkum, Calciumcarbonat und Magnesiumcarbonat ist.

6. Harzzusammensetzung nach Anspruch 1, weiterhin umfassend:
einen Härtungsbeschleuniger.

7. Harzzusammensetzung nach Anspruch 1, wobei auf Grundlage von 100 Gew.-% der Harzzusammensetzung die Harzzusammensetzung Folgendes umfasst:
8 bis 16 Gew.-% kautschukmodifiziertes Epoxidharz;
50 bis 65 Gew.-% Epoxidharz;
5 bis 10 Gew.-% anorganischen Füllstoff; und
20 bis 30 Gew.-% Härter.

8. Laminat für eine gedruckte Leiterplatte, umfassend:
eine Metallbasisschicht; und
eine durch Aufbringen der Harzzusammensetzung nach einem der Ansprüche 1 bis 7 auf die Metallbasisschicht gehärtete Harzschicht.

9. Gedruckte Leiterplatte, umfassend das Laminat für eine gedruckte Leiterplatte nach Anspruch 8.

## Revendications

1. Composition de résine, comprenant :
une résine époxy modifiée par caoutchouc ;
une résine époxy ;
une charge inorganique ; et
un agent de durcissement,
dans laquelle la résine époxy modifiée par caoutchouc est une résine obtenue en polymérisant un caoutchouc butadiène acrylonitrile terminé par un carboxyle (CTBN) avec une résine époxy de type phénol novolaque.

2. Composition de résine selon la revendication 1, dans laquelle la résine époxy modifiée par caoutchouc est comprise en une quantité de 8 à 16 % en poids sur la base de 100 % en poids de la composition de résine.

3. Composition de résine selon la revendication 1, dans laquelle la résine époxy modifiée par caoutchouc a un poids équivalent d'époxy de 300 à 500 g/éq et un poids moléculaire moyen en poids (Mw) de 30 000 à 60 000.

4. Composition de résine selon la revendication 1, dans laquelle la résine époxy est une ou plusieurs choisies dans le groupe constitué par une résine époxy de type bisphénol-A, une résine époxy de type bisphénol-A hydrogéné, une résine époxy de type bisphénol-F, une résine époxy de type bisphénol-S, une résine époxy de type novolaque, une résine époxy de type crésol novolaque, une résine époxy de type phénol novolaque, une résine époxy de type dicyclopentadiène, une résine époxy de type triphénylméthane, une résine époxy de type naphtalène, une résine époxy de type biphényle, une résine époxy de type biphényle hydrogéné et une résine époxy contenant du phosphore (P).

5. Composition de résine selon la revendication 1, dans laquelle la charge inorganique est un ou plusieurs choisis dans le groupe constitué par l'oxyde de silicium, l'oxyde d'aluminium, l'oxyde de zinc, le nitrure d'aluminium, le nitrure de silicium, le nitrure de bore, la silice, le talc, le carbonate de calcium et le carbonate de magnésium.

6. Composition selon la revendication 1, comprenant en outre :
un accélérateur de durcissement.

7. Composition de résine selon la revendication 1, dans laquelle sur la base de 100 % en poids de la composition de résine, la composition de résine comprend :
8 à 16 % en poids de la résine époxy modifiée par caoutchouc ;
50 à 65 % en poids de la résine époxy ;
5 à 10 % en poids de la charge inorganique ; et
20 à 30 % en poids de l'agent de durcissement.

8. Stratifié pour carte de circuit imprimé, comprenant :
une couche de base métallique, et
une couche de résine durcie par application de la composition de résine selon l'une quelconque des revendications 1 à 7 sur la couche de base métallique.

9. Carte de circuit imprimé comprenant le stratifié pour carte de circuit imprimé selon la revendication 8.
